# EUROPÄISCHE PATENTANMELDUNG

(11) **EP 2 613 219 A2**
(43) Veröffentlichungstag der Anmeldung: **10.07.2013**
(21) Anmeldenummer: 12198617.8
(22) Anmeldetag: 20.12.2012
(51) Int. Cl.: G06F 1/18

(54) **Gehäuse für ein Computersystem sowie Computersystem mit einem derartigen Gehäuse**

(30) Priorität: 04.01.2012 DE 102012100058
(71) Anmelder: Fujitsu Technology Solutions Intellectual Property GmbH, 80807 München (DE)
(72) Erfinder: Neukam, Wilhelm, 86399 Bobingen (DE)
(74) Vertreter: Epping - Hermann - Fischer

(57) **Zusammenfassung**

Die Erfindung betrifft ein Gehäuse (1) für ein Computersystem, wobei das Gehäuse (1) zumindest an einer ersten Gehäusewandung (2a, 2b) zum Zugang in das Gehäuse (1) geöffnet werden kann und wobei an einer zweiten Gehäusewandung (3) eine Öffnung (4) für einen externen Anschlussstecker angeordnet ist. Erfindungsgemäß weist das Gehäuse (1) eine Abdeckvorrichtung zum Abdecken der Öffnung (4) für den Anschlussstecker auf, wobei die Abdeckvorrichtung über die erste Gehäusewandung (2a, 2b) derart bedienbar ist, dass die Öffnung (4) für den externen Anschlussstecker zumindest teilweise abgedeckt ist, wenn das Gehäuse (1) geöffnet ist, und die Öffnung (4) für den externen Anschlussstecker nicht abgedeckt ist, wenn das Gehäuse (1) geschlossen ist.

Ferner wird ein Computersystem mit einem derartigen Gehäuse beschrieben.

## Beschreibung

Die Erfindung betrifft ein Gehäuse für ein Computersystem, wobei das Gehäuse zumindest an einer ersten Gehäusewandung zum Zugang in das Gehäuse geöffnet werden kann und wobei an einer zweiten Gehäusewandung eine Öffnung für einen externen Anschlussstecker angeordnet ist.

Ferner betrifft die Erfindung ein Computersystem mit einem derartigen Gehäuse.

Computersysteme weisen elektronische Komponenten auf, welche stromführend sind und/oder an denen eine elektrische Spannung anliegt. Beim Öffnen eines Gehäuses eines Computersystems besteht bei unsachgemäßer Bedienung die Gefahr eines elektrischen Schlags (so genannte Energiegefahr oder Gefahr eines Elektrounfalls). Eine unsachgemäße Bedienung ist beispielsweise dadurch gegeben, dass das Computersystem bei geöffnetem Gehäuse über einen externen Anschlussstecker nach außen mit einer Strom- oder Spannungsquelle verbunden ist. Dies kann beispielsweise über eine Stromversorgungseinheit (wie ein Netzteil) erfolgen, welche mit dem Stromversorgungsnetz verbunden ist.

Insbesondere bei Computersystemen, bei denen die Stromversorgung zur Umwandlung der netzseitigen Wechselspannung in eine Versorgungsspannung innerhalb des Gehäuses des Computersystems angeordnet ist, liegen an elektronischen Komponenten im Gehäuse hohe (Eingangs-) Spannungen an.

Es ist Aufgabe der Erfindung, ein Computersystem sicherer gegen unsachgemäße Bedienung zu machen, sodass die Energiegefahr für einen Benutzer erheblich reduziert bzw. unterbunden wird.

Die Aufgabe wird durch ein Gehäuse der eingangs genannten Art dadurch gelöst, dass das Gehäuse eine Abdeckvorrichtung zum Abdecken der Öffnung für den Anschlussstecker aufweist, wobei die Abdeckvorrichtung über die erste Gehäusewandung derart bedienbar ist, dass die Öffnung für den externen Anschlussstecker zumindest teilweise abgedeckt ist, wenn das Gehäuse geöffnet ist, und die Öffnung für den externen Anschlussstecker nicht abgedeckt ist, wenn das Gehäuse geschlossen ist.

Ein derartiges Gehäuse hat den Vorteil, dass bei geöffnetem Gehäuse Anschlussmöglichkeiten für externe Anschlussstecker blockiert sind. Es kann dann kein externer Anschlussstecker durch die Öffnung des Gehäuses geführt und mit elektronischen Komponenten im Gehäuse verbunden werden. Auf diese Weise ist es nicht möglich, elektronische Komponenten, welche im Gehäuse angeordnet sind, mit dem Stromversorgungsnetz über einen externen Anschlussstecker zu verbinden, wenn das Gehäuse geöffnet ist.

Die Abdeckvorrichtung ist derart mit der ersten Gehäusewandung, welche geöffnet werden kann, gekoppelt, dass die Abdeckvorrichtung die Öffnung für den externen Anschlussstecker an der zweiten Gehäusewandung zumindest teilweise abdeckt, beziehungsweise verdeckt, sobald das Gehäuse an der ersten Gehäusewandung geöffnet wird. Somit ist ein Verdecken von Anschlussmöglichkeiten an einer Gehäusewandung durch das Öffnen des Gehäuses an einer anderen Gehäusewandung steuerbar.

Die Begriffe "erste" und "zweite" Gehäusewandung beschreiben unterschiedliche Gehäusewandungen an einem Gehäuse. Das bedeutet, dass die erste Gehäusewandung sich beispielsweise über eine erste Fläche erstreckt, wobei sich die zweite Gehäusewandung über eine zweite Fläche erstreckt. Die beiden Flächen sind nicht parallel zueinander ausgebildet. Im einfachsten Fall kann die erste Gehäusewandung nahezu senkrecht zur zweiten Gehäusewandung ausgeführt sein. Beispielsweise kann die erste Gehäusewandung eine Seitenwand eines Gehäuses und die zweite Gehäusewandung eine Rückwand eines Gehäuses sein.

Ein Gehäuse der vorliegenden Art vermeidet eine unsachgemäße Bedienung, welche darin besteht, dass ein Computersystem, das im Gehäuse aufgenommen ist, mit dem Stromversorgungsnetz verbunden wird, obwohl das Gehäuse geöffnet ist. Somit wird verhindert, dass für einen Benutzer elektronische Komponenten im Gehäuseinnenraum zugänglich sind, welche stromführend sind beziehungsweise an denen eine elektrische Spannung anliegt. Somit wird die Gefahr eines elektrischen Schlags bzw. eines Elektrounfalls durch das vorgenannte Gehäuse erheblich reduziert oder sogar verhindert.

Insbesondere ist ein derartiges Gehäuse vorteilhaft für Computersysteme einsetzbar, bei denen die Stromversorgungseinheit, d.h. das Netzteil, in das Gehäuse integriert ist. Die Stromversorgungseinheit kann dabei fest in das Gehäuse integriert sein, sodass diese nicht entnommen werden kann.

In einer Ausführungsform wirkt die erste Gehäusewandung mit der Abdeckvorrichtung mechanisch zusammen, wenn das Gehäuse geschlossen ist, wobei die erste Gehäusewandung mit der Abdeckvorrichtung nicht mechanisch zusammenwirkt, wenn das Gehäuse geöffnet ist. Das bedeutet, dass die Abdeckvorrichtung die Öffnung für den externen Anschlussstecker nur bei Zusammenwirken mit der ersten Gehäusewandung offen hält und die Öffnung zumindest teilweise abdeckt, wenn die Abdeckvorrichtung mit der ersten Gehäusewandung nicht mechanisch zusammenwirkt (also wenn das Gehäuse an der ersten Gehäusewandung geöffnet ist). Die Abdeckvorrichtung ist ohne Einwirkung der ersten Gehäusewandung somit in einem Zustand, in dem sie selbständig die Öffnung für den externen Anschlussstecker abdeckt, wobei die Abdeckvorrichtung nur bei Zusammenwirken mit der ersten Gehäusewandung in einen Zustand bringbar ist, in dem die Öffnung für den externen Anschlussstecker offen ist, sodass ein externer Anschlussstecker durch die Öffnung in das Gehäuse eingeführt werden kann.

In einer Ausführungsform umfasst die Abdeckvorrichtung zumindest einen Schieber, welcher zwischen einer ersten Position und einer zweiten Position verschiebbar ist, wobei der Schieber in der ersten Position die Öffnung zumindest teilweise abdeckt und in der zweiten Position die Öffnung nicht abdeckt. Der zumindest eine Schieber kann zwischen der ersten und der zweiten Position hin und her geschoben werden. Der Schieber kann dabei eine translatorische oder rotatorische Bewegung oder eine Kombination aus einer translatorischen und rotatorischen Bewegung vollführen.

Es ist denkbar, dass der Schieber selbst mit der ersten Gehäusewandung mechanisch zusammenwirkt. Alternativ ist denkbar, zumindest ein Kopplungselement zwischen dem Schieber und der ersten Gehäusewandung zur Zwangskopplung der ersten Gehäusewandung mit dem Schieber vorzusehen.

Ferner ist denkbar, alternativ zu einem Schieber einen anderen Mechanismus vorzusehen. So könnte beispielsweise auch ein Klappmechanismus mit einer Art Klappe vorgesehen sein, welche bei mechanischem Kontakt mit der ersten Gehäusewandung in einer Position gehalten wird, in der die Öffnung für den externen Anschlussstecker offengehalten wird, und bei Öffnen des Gehäuses an der ersten Gehäusewandung in eine Position geschwenkt wird, in der die Öffnung für den externen Anschlussstecker zumindest teilweise von der Klappe abgedeckt beziehungsweise verdeckt wird. Die Klappe könnte beispielsweise durch Schwerkraft nach unten fallen und die Öffnung abdecken, wenn die erste Gehäusewandung geöffnet wird.

Die Ausführung der Abdeckvorrichtung als Schieber kann dahingehend weitergebildet sein, dass der Schieber über ein flexibles Element gefedert gelagert ist. Der Schieber ist bei Entspannung des flexiblen Elements in der ersten Position und kann entgegen einer Kraft des flexiblen Elements von der ersten Position in die zweite Position gebracht werden. Das flexible Element kann jegliche Art von Federung sein. Der Vorteil der Kopplung des Schiebers mit einem flexiblen Element besteht darin, dass der Schieber automatisch in die erste Position bewegt und dort gehalten wird, wenn die erste Gehäusewandung geöffnet ist. Nur bei mechanischem Zusammenwirken der ersten Gehäusewandung mit der Abdeckvorrichtung beziehungsweise unmittelbar mit dem Schieber wird der Schieber entgegen der Kraft des flexiblen Elements in die zweite Position gebracht und dort gehalten. Sobald das Gehäuse an der ersten Gehäusewandung geöffnet wird, wird der Schieber durch die Kraft des flexiblen Elements von der zweiten Position in die erste Position zum Abdecken der Öffnung für den externen Anschlussstecker gezwungen. Dies hat den Vorteil, dass nach dem Öffnen keine weitere Bedienaktion durchgeführt werden muss, um die Öffnung abzudecken. Ferner gewährleistet ein gefederter Mechanismus ein sicheres und verlässliches Abdecken der Öffnung, sobald das Gehäuse geöffnet ist.

Auch bei alternativen Ausführungen einer Abdeckvorrichtung, zum Beispiel als Klappmechanismus wie oben erläutert, kann ein flexibles Element vorgesehen sein, um ein automatisches Abdecken der Öffnung durch die Abdeckvorrichtung auszulösen, wenn das Gehäuse an der ersten Gehäusewandung geöffnet ist.

In einer Ausführung der Abdeckvorrichtung mit einem Schieber ragt der Schieber in der ersten Position über die zweite Gehäusewandung hinaus und kann bei Kontakt mit der ersten Gehäusewandung in die zweite Position gedrückt werden. In dieser Ausführung wirkt der Schieber unmittelbar mechanisch mit der ersten Gehäusewandung zusammen. Der Schieber ist über die erste Gehäusewandung bedienbar und wird von der ersten Gehäusewandung betätigt, wenn diese zum Verschließen des Gehäuses in eine geschlossene Position gebracht wird. Dann drückt die erste Gehäusewandung auf den Schieber, sodass dieser von der ersten Position in die zweite Position gedrückt wird und die Öffnung aufdeckt. In der zweiten Position wird dann die Öffnung für den externen Anschlussstecker offengehalten.

Vorteilhaft ist ein Computersystem mit einem Gehäuse der beschriebenen Art ausgebildet, wobei im Gehäuse zumindest ein Systemboard des Computersystems sowie hinter der Öffnung an der zweiten Gehäusewandung des Gehäuses ein Stromversorgungsanschluss zum elektrischen Zusammenwirken mit einem externen Anschlussstecker angeordnet ist. Zur Versorgung des Computersystems mit elektrischer Energie kann ein externer Anschlussstecker durch die Öffnung des Gehäuses mit dem Stromversorgungsanschluss im Gehäuse verbunden werden, sodass dem Computersystem von außen elektrische Energie zugeführt werden kann.

In einer Ausführungsform umfasst das Computersystem eine Stromversorgungseinheit, welche im Gehäuse des Computersystems, beispielsweise auf dem Systemboard, angeordnet ist. Die Stromversorgungseinheit kann dabei fest im Gehäuse des Computersystems montiert sein, sodass die Stromversorgungseinheit nicht ausbaubar ist. Dem Computersystem kann von außen elektrische Wechselspannung des Stromversorgungsnetzes - in der Regel 230 V - zugeführt werden. Gerade im letztgenannten Fall ist es vorteilhaft, einen Anschluss des Computersystems an das Stromversorgungsnetz und somit ein Anliegen von Wechselspannung an elektronische Komponenten im Gehäuse des Computersystems dadurch zu unterbinden, dass die Öffnung für den externen Anschlussstecker am Gehäuse gemäß der erläuterten Art abgedeckt wird, wenn das Gehäuse des Computersystems an der ersten Gehäusewandung geöffnet ist. Somit wird die Gefahr eines elektrischen Schlags für ein Bedien- oder Servicepersonal des Computersystems erheblich reduziert.

In unterschiedlichen Ausführungsformen ist das Computersystem ein Thin Client, ein All-in-one-PC oder ein Mini-PC.

Weitere vorteilhafte Ausführungsformen werden in den Unteransprüchen sowie in der nachfolgenden Figurenbeschreibung offenbart. Der Gegenstand wird anhand mehrerer Zeichnungen erläutert.

Es zeigen:
- Figur 1: eine perspektivische Darstellung einer Vorderansicht eines Teils eines Gehäuses,
- Figur 2: eine perspektivische Darstellung einer Rückansicht eines Teils des Gehäuses gemäß Figur 1,
- Figur 3: eine perspektivische Darstellung des Gehäuses gemäß Figur 1 mit einer weiteren montierten Gehäusewandung und
- Figur 4: eine perspektivische Darstellung des Gehäuses gemäß Figur 3 mit einer weiteren montierten Gehäusewandung.

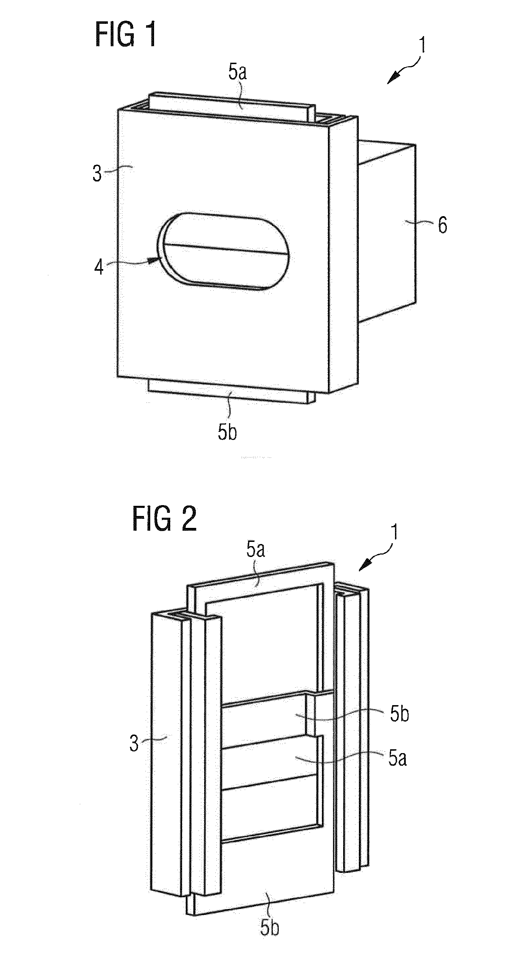

Figur 1 zeigt eine perspektivische Darstellung eines Teils einer Gehäusewandung 3, welche Teil eines Gehäuses 1 für ein Computersystem bildet. Die Gehäusewandung 3 ist beispielsweise eine Rück- oder Seitenwand eines Gehäuses 1 für ein Computersystem und weist eine Öffnung 4 für einen oder mehrere Anschlussstecker auf, wobei der oder die Anschlussstecker im Betrieb eines Computersystems durch die Öffnung 4 hindurchgeführt werden können. Gemäß der Darstellung in Figur 1 liegt hinter der Öffnung 4 schematisiert im Innenraum des Gehäuses 1 ein Stromversorgungsanschluss 6 zum Anschluss eines Computersystems an das Stromversorgungsnetz.

In dem in Figur 1 dargestellten Zustand ist die Öffnung 4 jedoch über zwei Schieber 5a und 5b verdeckt und vollständig geschlossen. Somit ist gemäß Figur 1 ein Einführen eines externen Anschlusssteckers durch die Öffnung 4 in das Gehäuse 1 verhindert.

Figur 1 zeigt einen Zustand des Gehäuses 1, in dem das Gehäuse 1 an zwei weiteren Gehäusewandungen (nicht dargestellt) geöffnet ist. Dies kann beispielsweise zu Wartungszwecken erfolgen. Sobald das Gehäuse 1 derart geöffnet ist, fahren die Schieber 5a und 5b in die in Figur 1 dargestellten Positionen.

Die Schieber 5a und 5b sind über weitere Gehäusewandungen des Gehäuses 1 bedienbar, wie nachfolgend erläutert wird.

Figur 2 zeigt eine perspektivische Darstellung des Teils der Gehäusewandung 3 des Gehäuses 1 nach Figur 1. Insbesondere ist in Figur 2 die Ausführung der beiden Schieber 5a und 5b dargestellt. Die Schieber 5a und 5b sind derart ausgeführt, dass sie entlang einer vorbestimmten Richtung verschoben werden können. Die Schieber 5a und 5b werden dabei jeweils in einer Führung zwangsgeführt. Die Führung kann Teil der Gehäusewandung 3 oder ein oder mehrere separate Teile sein.

Die Schieber 5a und 5b bilden zusammen eine Kulisse, wobei der Schieber 5a einen unteren Teil einer Abdeckung (siehe Figur 1) umfasst und der Schieber 5b einen oberen Teil der Abdeckung umfasst. Wird der Schieber 5a von der in Figur 2 dargestellten ersten Position nach unten gefahren, so bewegt sich auch der durch den Schieber 5a gebildete untere Teil der Abdeckung nach unten.

Ähnliches gilt für den Schieber 5b. Wird der Schieber 5b von der in Figur 2 dargestellten Position nach oben gefahren, so bewegt sich der durch den Schieber 5b gebildete obere Teil der Abdeckung nach oben. Die Schieber 5a und 5b greifen derart ineinander, dass die Öffnung 4 (siehe Figur 1) vollständig geöffnet werden kann, wenn beide Schieber 5a und 5b von der in Figur 2 dargestellten Position translatorisch zusammengeschoben werden.

Die Schieber 5a und 5b können jeweils über ein oder mehrere Federelemente (nicht dargestellt) gefedert gelagert sein. Dabei ist die Federung vorteilhaft derart eingerichtet, dass die Schieber 5a und 5b ohne mechanische Einwirkung von außen in der in Figur 2 gezeigten Position stehen und nur entgegen einer Federkraft zusammengeschoben werden können.

Gemäß den Figuren 1 und 2 sind die Schieber 5a und 5b derart kulissenartig an der Gehäusewandung 3 angeordnet, dass sie in entgegensetzter Richtung über die Gehäusewandung 3 hinausragen. Auf diese Weise können die Schieber 5a und 5b von weiteren Gehäusewandungen betätigt werden, wie nachfolgend erläutert wird.

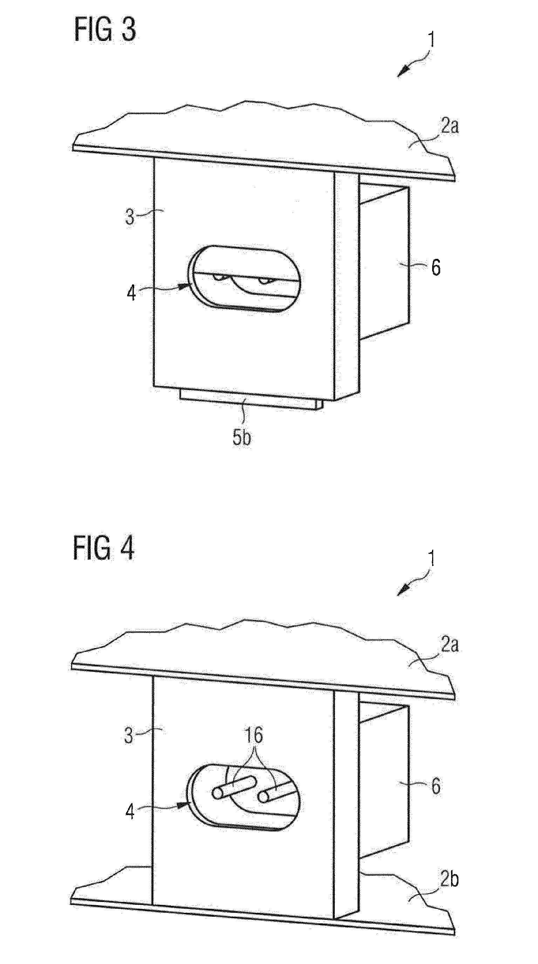

Figur 3 zeigt die Gehäusewandung 3 gemäß Figur 1, wobei an der Gehäusewandung 3 ein Teil einer weiteren Gehäusewandung 2a anliegt. Die Gehäusewandung 2a bildet beispielsweise eine Art Deckel beziehungsweise Abdeckung, um das Gehäuse 1 nach oben hin abzuschließen. Die Gehäusewandung 2a kann beispielsweise ein oberes Abdeckblech des Gehäuses 1 bilden.

Die Gehäusewandung 2a liegt an der Gehäusewandung 3 an und wirkt mit dem oberen Schieber 5a (siehe Figur 2) mechanisch zusammen, sodass der Schieber 5a von der in Figur 2 gezeigten Position nach unten verschoben wurde. Dadurch wurde auch der dem Schieber 5a zugeordnete Teil der Abdeckung der Öffnung 4 kulissenartig nach unten bewegt, sodass die Öffnung 4 im unteren Teilbereich eröffnet ist.

Der zweite Schieber 5b ist jedoch unverändert in der Position gemäß Figur 2, sodass die Öffnung 4 von dem Schieber 5b zumindest teilweise abgedeckt beziehungsweise verdeckt bleibt. Ein Einführen eines externen Anschlusssteckers durch die Öffnung 4 in das Innere des Gehäuses 1, beispielsweise zum Kontaktieren mit einem Stromversorgungsanschluss 6, ist gemäß Figur 3 weiterhin nicht möglich. Eine Situation gemäß Figur 3 ist beispielsweise dadurch gegeben, dass das Gehäuse 1 zwar an einer Oberseite mit einer Gehäusewandung 2a verschlossen ist, die Unterseite des Gehäuses 1 jedoch noch geöffnet ist.

Figur 4 zeigt die Gehäusewandung 3 des Gehäuses 1, wobei neben der Gehäusewandung 2a an der Oberseite des Gehäuses 1 noch ein Teil einer weiteren Gehäusewandung 2b an der Unterseite des Gehäuses 1 angeordnet ist. Wie im Falle der Gehäusewandung 2a liegt auch die Gehäusewandung 2b an der Gehäusewandung 3 an. Auf diese Weise wirkt die Gehäusewandung 2b mit dem unteren Schieber 5b (siehe Figuren 2 und 3) zusammen, sodass der Schieber 5b von der in den Figuren 2 und 3 dargestellten Position nach oben verschoben wurde. Dadurch wurde der dem unteren Schieber 5b zugeordnete Teil der Abdeckung der Öffnung 4 kulissenartig nach oben verschoben, sodass gemäß Figur 4 die Öffnung 4 nun vollständig eröffnet ist. Auf diese Weise sind Anschlusskontakte 16 eines Stromversorgungsanschlusses 6 zugänglich, welcher innerhalb des Gehäuses 1 angeordnet ist und beispielsweise zum Anschluss eines Computersystems an ein Stromversorgungsnetz dient.

Eine Situation gemäß Figur 4 ist beispielsweise dadurch gegeben, dass das Gehäuse 1 vollständig durch Gehäusewandungen 2a und 2b verschlossen ist. In diesem Falle, und nur in diesem Falle, kann ein externer Anschlussstecker durch die Öffnung 4 in das Gehäuse 1 eingeführt werden und mit Anschlusskontakten 16 des Stromversorgungsanschlusses 6 kontaktiert werden.

Auf die erläuterte Art und Weise wird ein externer Anschluss eines Computersystems im Gehäuse 1 mit dem Stromversorgungsnetz verhindert, wenn eine oder mehrere Gehäusewandungen 2a und 2b des Gehäuses 1 abgenommen sind, sodass das Gehäuse 1 geöffnet ist. Auf diese Weise wird die Gefahr eines elektrischen Schlags und damit die Gefährdung eines Bedienpersonals erheblich reduziert.

In nicht dargestellten Ausführungsformen kann ein Gehäuse 1 auch nur einen Schieber aufweisen. Dieser könnte sich dann über den gesamten Querschnitt einer Öffnung 4 erstrecken und die Öffnung 4 abdecken, wenn eine dem Schieber zugeordnete Gehäusewandung geöffnet ist. Ferner könnten zwei Schieber die Öffnung 4 jeweils vollständig abdecken, wobei die Abdeckbereiche der Schieber senkrecht zum Querschnitt der Öffnung 4 hintereinander angeordnet sind. Dann wäre die Öffnung 4 immer vollständig verdeckt, wenn zumindest eine Gehäusewandung geöffnet ist, und nur dann eröffnet, wenn das Gehäuse 1 vollständig geschlossen ist.

Es ist auch denkbar, über eine Abdeckvorrichtung durch einen oder mehrere Schieber auch mehrere Öffnungen 4 an einer Gehäusewandung 3 abzudecken. Es ist beispielsweise denkbar, einen gesamten I/O-Slot an einer Rückwand eines Computersystems zur Konnektierung verschiedener Steckeranschlüsse über eine erläuterte Abdeckvorrichtung abzudecken, wenn das Gehäuse 1 geöffnet ist.

Ferner ist denkbar, neben den dargestellten Schiebern 5a und 5b andere Mechanismen, beispielsweise einen Klappmechanismus vorzusehen, welcher betätigt wird, wenn eine oder mehrere Gehäusewandungen 2a oder 2b vom Gehäuse 1 abgenommen sind.

### Bezugszeichenliste

- 1: Gehäuse
- 2a, 2b: erste Gehäusewandung
- 3: zweite Gehäusewandung
- 4: Öffnung für externen Anschlussstecker
- 5a, 5b: Schieber
- 6: Stromversorgungsanschluss
- 16: Anschlusskontakte

## Patentansprüche

1. Gehäuse (1) für ein Computersystem, wobei das Gehäuse (1) zumindest an einer ersten Gehäusewandung (2a, 2b) zum Zugang in das Gehäuse (1) geöffnet werden kann und wobei an einer zweiten Gehäusewandung (3) eine Öffnung (4) für einen externen Anschlussstecker angeordnet ist,
**dadurch gekennzeichnet, dass**
das Gehäuse (1) eine Abdeckvorrichtung zum Abdecken der Öffnung (4) für den Anschlussstecker aufweist, wobei die Abdeckvorrichtung über die erste Gehäusewandung (2a, 2b) derart bedienbar ist, dass die Öffnung (4) für den externen Anschlussstecker zumindest teilweise abgedeckt ist, wenn das Gehäuse (1) geöffnet ist, und die Öffnung (4) für den externen Anschlussstecker nicht abgedeckt ist, wenn das Gehäuse (1) geschlossen ist.

2. Gehäuse (1) nach Anspruch 1,
**dadurch gekennzeichnet, dass** die erste Gehäusewandung (2a, 2b) mit der Abdeckvorrichtung mechanisch zusammenwirkt, wenn das Gehäuse (1) geschlossen ist und die erste Gehäusewandung (2a, 2b) mit der Abdeckvorrichtung nicht mechanisch zusammenwirkt, wenn das Gehäuse (1) geöffnet ist.

3. Gehäuse (1) nach Anspruch 1 oder 2,
**dadurch gekennzeichnet, dass**
die Abdeckvorrichtung zumindest einen Schieber (5a, 5b) umfasst, welcher zwischen einer ersten Position und einer zweiten Position verschiebbar ist, wobei der Schieber (5a, 5b) in der ersten Position die Öffnung (4) zumindest teilweise abdeckt und in der zweiten Position die Öffnung (4) nicht abdeckt.

4. Gehäuse (1) nach Anspruch 3,
**dadurch gekennzeichnet, dass** der Schieber (5a, 5b) über ein flexibles Element gefedert gelagert ist, wobei der Schieber (5a, 5b) bei Entspannung des flexiblen Elements in der ersten Position ist und entgegen einer Kraft des flexiblen Elements von der ersten Position in die zweite Position bringbar ist.

5. Gehäuse (1) nach Anspruch 3 oder 4,
**dadurch gekennzeichnet, dass** der Schieber (5a, 5b) in der ersten Position über die zweite Gehäusewandung (3) hinausragt und bei Kontakt mit der ersten Gehäusewandung (2a, 2b) in die zweite Position gedrückt werden kann.

6. Gehäuse (1) nach einem der Ansprüche 1 bis 5,
**dadurch gekennzeichnet, dass** die erste Gehäusewandung (2a, 2b) zum Öffnen des Gehäuses (1) gegenüber dem Gehäuse (1) schwenkbar oder vollständig vom Gehäuse (1) abnehmbar ist.

7. Computersystem mit einem Gehäuse (1) nach einem der Ansprüche 1 bis 6, wobei im Gehäuse (1) zumindest ein Systemboard sowie hinter der Öffnung (4) an der zweiten Gehäusewandung (3) ein Stromversorgungsanschluss (6) zum elektrischen Zusammenwirken mit einem externen Anschlussstecker angeordnet ist.

8. Computersystem nach Anspruch 7, wobei der Stromversorgungsanschluss (6) nicht mit einem externen Anschlussstecker verbunden werden kann, wenn die Öffnung (4) für den externen Anschlussstecker zumindest teilweise über die Abdeckvorrichtung abgedeckt ist.

9. Computersystem nach Anspruch 7 oder 8, wobei das Computersystem ein Thin Client, All-in-One-PC oder Mini-PC ist.
